# EUROPEAN PATENT APPLICATION

(11) **EP 1 978 753 A1**
(43) Date of publication of application: **08.10.2008**
(21) Application number: 07713665.3
(22) Date of filing: 16.01.2007
(51) Int. Cl.: H04N 9/07, H04N 5/225

(54) **OPTICAL LOW PASS FILTER AND IMAGING DEVICE USING THE SAME**

(30) Priority: 20.01.2006 JP 2006012672
(71) Applicant: Acutelogic Corporation, 3-7-1, Kanda-Ogawamachi Chiyoda-ku, Tokyo 101-0052 (JP)
(72) Inventor: MASUDA, Takashi, Tokyo 101-0052 (JP); SEI, Masafumi, Tokyo 101-0052 (JP); HONDA, Masahiko, Tokyo 101-0052 (JP); KUBOTA, Hidetoshi, Tokyo 101-0052 (JP); WAKI, Kenichiro, Tokyo 101-0052 (JP)
(74) Representative: Vossius & Partner
(86) International application number: PCT/JP2007/050861
(87) International publication number: WO 2007/083783

(57) **Abstract**

An optical low pass filter (2) is formed, for example, by a birefringent plate so as to control the light beam separation width, thereby changing the cut-off frequency according to an imaging mode. The number of pixels of an imaging element (5) is set greater than the number of pixels corresponding to the dynamic image display resolution. In a still image capturing mode, the light beam separation width is set narrower so that the resolution of the imaging element (5) can be used as it is while suppressing generation of a false color to a certain degree. On the other hand, in a dynamic image capturing mode, the light beam separation width is set wider so that a high-frequency component corresponding to an unnecessary resolution component for an output image signal can be cut off and suppression of the false color can be performed strongly as compared to the still image capturing mode.

## Description

### Technical Field

The present invention relates to an optical low pass filter and an imaging device using the same, and in particular, the invention is suitably used for an optical filter to remove a high-frequency component by utilizing a blur condition of an image. Further, the invention is suitably used for a hybrid camera configured to be able to capture both of a dynamic image and a still image by one set of a camera.

### Background Art

In recent years, a so-called hybrid camera configured to be able to capture both of a dynamic image and a still image by one set of a camera has been provided in the market. Together with this, a device for improving the image quality of the dynamic image and the still image to be captured has been conceived. For example, in almost all the hybrid cameras, an imaging element (image sensor) having a large number of pixels to increase a resolution of the still image is employed. Further, to suppress the generation of a false color (color moiré) by sampling is an important factor to improve an image quality.

Here, a description will be made on a principle of the generation of the false color. The imaging element is an assembly of micro pixels, and to capture an optical image by the imaging element is equivalent to the sampling of signals at intervals of a pixel pitch. For example, in the imaging element whose photo diodes (pixels) are disposed in a square lattice shape, assuming that the pixel pitch is taken as d, a sampling frequency fs becomes fs=1/d.

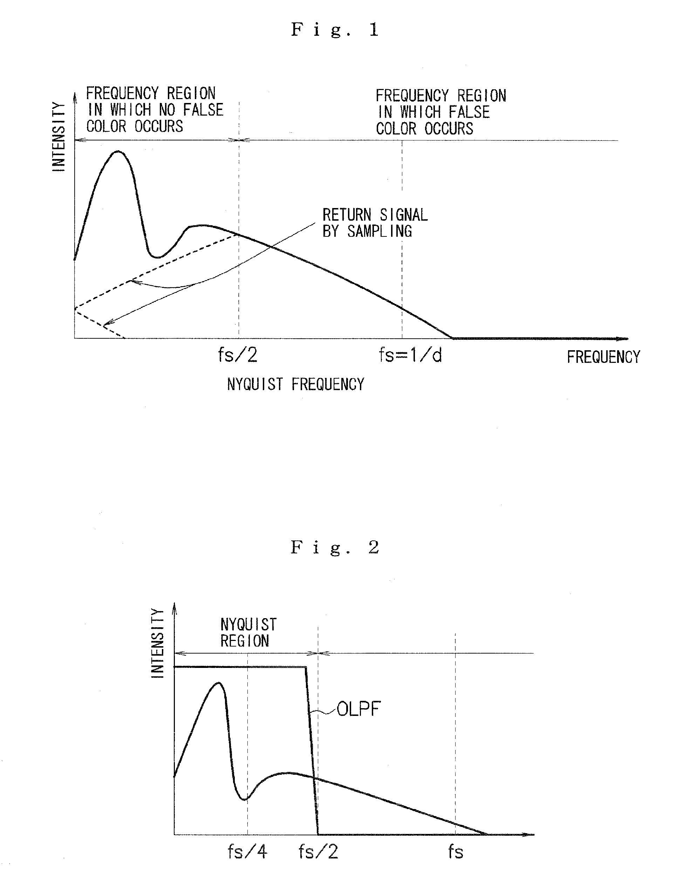

At this time, as shown in Figure 1, a frequency region larger than a Nyquist frequency (=fs/2) in the frequency region becomes folded return components at a real space, and comes out as a pattern (false color) which does not exist in reality. That is, as shown by a solid line of Figure 1, when the spatial frequency of an object exceeds the Nyquist frequency of the imaging element, there is the possibility that the false color may occur in the object.

Hence, usually, as shown in Figure 2, an optical low pass filter (OLPF) setting a Nyquist frequency (fs/2) of the imaging element to a cut-off frequency fc (=fs/2) is provided in an optical path, and an imaging light entering the imaging element is filtered (for example, see Patent Documents 1 and 2).
Patent Document 1: Japanese Patent Laid-Open No. 6-292093
Patent Document 2: Japanese Patent No. 2556831

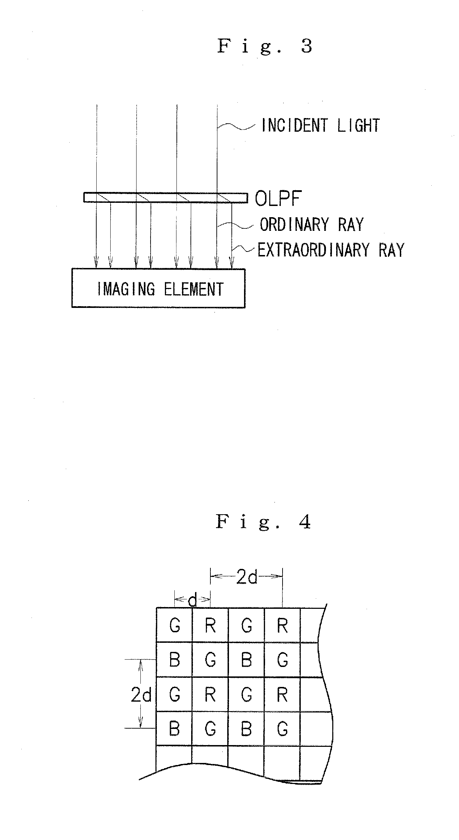

The optical low pass filter is an optical filter composed of a birefringent plate made of quartz crystal, lithium niobate, and the like as a base material, and removing a high-frequency component by utilizing birefringence of the light. That is, as shown in Figure 3, the birefringent plate has property of separating the incident light into an ordinary ray and an extraordinary ray, and therefore, if this plate is disposed in the image-forming optical path to the imaging element, an image-forming surface of the imaging element is formed with a double image by being superposed with an image by the ordinary ray and an image by the extraordinary ray. As a result, the birefringent plate functions as the optical low pass filter for removing a spatial frequency component equivalent to the wavelength of a size two times that of a light beam separation width (an interval between the ordinary ray and the extraordinary ray) from among the object images. Since the light beam separation width is proportionate to a thickness of the birefringent plate, if the thickness of the birefringent plate is decided so that the separation width of the double image becomes almost equal to the pixel pitch of the imaging element, the generation of the false color can be suppressed.

### Disclosure of the Invention

However, as shown in Figure 4, in the case of the imaging element in which color filters are disposed in the Bayer pattern on the imaging pixels disposed in a square lattice shape, pixel pitches of G colors (Green) in the longitudinal and lateral directions are d, whereas the pixel pitches of R color (Red) and B color (Blue) are 2d, so that the Nyquist frequencies of the R color and the B color become fs/4 (assuming that fs=1/d, fs is equivalent to the sampling frequency of the G color). Consequently, to completely prevent the generation of the false color, the cut-off frequency fc of the optical low pass filter is preferably set to fs/4 or less. When seen from the color aspect, the optimum optical low pass filter is set as above.

However, when seen from the resolution aspect, it is not possible to strengthen the effect of the optical low pass filter until a resolution feeling of the output image is deteriorated. That is, when the sampling frequency of the output image is taken as Fs and the pixel pitch is taken as D (=1/Fs), to allow the output image to carry sufficient resolution, it is necessary to set the cut-off frequency fc of the optical low pass filter approximately at least to Fs/2 (=1/2D) or to a level slightly exceeding this frequency.

In the digital camera having an imaging element of the ordinary Bayer pattern, the number of pixels of the imaging element and the number of pixels of the output image are at the same level (when set to a mode of the highest image quality of the camera). In this kind of the digital camera, the pixel pitch d of the imaging element and the pixel pitch D of the output image are equal to each other. In such a digital camera, the cut-off frequency fc of the optical low pass filter is set to approximately fs/2 (=1/2d) or to a level slightly exceeding this frequency.

This means that importance is attached to the resolution aspect rather than the color aspect. In this case, since the Nyquist frequency of the G color is fs/2, the false color of the G color is not so conspicuous, whereas the Nyquist frequencies of the R color and the B color are fs/4, respectively, and therefore, the false colors by the R color and the B color are left behind. However, in even such a case, if the object itself does not have a high-frequency component, the false color is not generated. Hence, an ordinary user is more likely to give preference to the resolution over the color. In the ordinary digital camera, the cut-off frequency fc of the optical low pass filter is set as described above in accordance to this preference.

In the ordinary digital camera, though preference is given to the resolution aspect over the color aspect, the present applicant devises a camera such that both of the color aspect and the resolution aspect are satisfied simultaneously (for example, see Patent Document 3). In this camera disclosed in Patent Document 3, from N pieces of the pixel signals generated by the imaging element, one piece of the output image signal is generated. The relationship between the pixel pitch d of the imaging element and the pixel pitch D of the output image is d<D. As a result, the cut-off frequency fc of the optical low pass filter can be set so as to satisfy both of the color aspect and the resolution aspect.

Patent Document 3: Japanese Patent Application No. 2004-156083

In general, when the image quality is to be improved, a still image is strongly required to be high in the number of pixels and have high resolution. In contrast to this, though a dynamic image is strongly required to have high resolution, the number of pixels has only to satisfy standards (approximately 350,000 pixels according to SD standards, and approximately 2,080,000 pixels according to HD standards). The number of pixels of the camera for the still image not required to correspond to the standards (several millions of pixels to over ten millions of pixels) is relatively higher as compared with the number of pixels satisfying the standards of the dynamic image. Further, in a camera for taking dynamic images, since a camera hardly generating a false color by using a 3-CCD type imaging element is in widespread use, it is also strongly required to suppress the generation of the false color similarly to this camera. However, both of the still image and the dynamic image are likely to give preference to the high resolution over the low false color.

When a hybrid camera designed to be able to take both of the still image and the dynamic image by one set of a camera is to be fabricated, it is not possible to set an appropriate frequency characteristic to the optical low pass filter simultaneously for both of the still image and the dynamic image. As described above, the cut-off frequency fc of the optical low pass filter most appropriate for the still image is approximately fs/2 (=1/2d) or slightly exceeds this frequency, and the cut-off frequency fc most appropriate for the dynamic image is lower than this frequency.

The present invention has been carried out in view of such circumstances, and an object of the invention is to enable the generation of the false color to be effectively suppressed without sacrificing the resolution of the output image with respect to the dynamic image, and at the same time, to suppress the generation of the false color as much as possible, while increasing the resolution sufficiently with respect to the still image.

To achieve the above described objects, the optical low pass filter of the present invention variably controls a blur condition of the image to be formed in the imaging element according to a still image taking mode or a dynamic image capturing mode. For example, by variably controlling the light beam separation width according to the still image capturing mode or the dynamic image capturing mode, at the time of a still image capturing mode, the light beam separation width is taken as a first width so that the blur condition of the image is taken as a first amount, and at the time of a dynamic image capturing mode, the light beam separation width is taken as a second width wider than the first width, so that the blur condition of the image is taken as a second amount.

Further, the imaging device of the present invention utilizing such an optical low pass filter is provided with the imaging element of many more pixel numbers than the display pixel number set up by the standards of the dynamic image, and at the time of the dynamic image capturing mode, one piece of the output image signal is generated from N pieces of the pixel signals generated by the imaging element.

According to the present invention thus configured, at the time of the still image capturing mode, the light beam separation width at the optical low pass filter is controlled so as to be relatively narrow. Since the cut-off frequency of the optical low pass filter depends on the light beam separation width, the light beam separation width is made relatively narrow and the cut-off frequency is controlled to become approximately fs/2 or to slightly exceed this frequency, so that the resolution of the imaging element can be used as it is while suppressing the generation of the false color to a certain degree. As a result, the still image with high resolution which satisfies high requirements and moreover with the minimum possible false color suppression can be obtained.

On the other hand, at the time of the dynamic image capturing mode, the light beam separation width at the optical low pass filter is controlled so as to be relatively wider, and from N pieces of the pixel signals generated by the imaging element, one piece of the output image signal is generated. The light beam separation width is made relatively wider and a control is made such that the cut-off frequency becomes a frequency equivalent to the Nyquist frequency of the pixel of the output image or slightly exceeds this frequency, so that a high-frequency component equivalent to a resolution component unnecessary for the output image signal can be cutoff by the optical low pass filter. Further, as compared with the still image capturing mode, the suppression of the false color can be strongly performed with allowance. As a result, the dynamic image with the resolution satisfying the requirements under the standards of the dynamic image and the effectively-suppressed false color can be obtained.

### Brief Description of the Drawings

Figure 1 is a frequency characteristic diagram showing the principle of generation of a false color;
Figure 2 is a view showing the frequency characteristic of an optical low pass filter cutting off the false color;
Figure 3 is a view showing the basic principle of the optical low pass filter;
Figure 4 is a view showing a pixel pitch of the Bayer pattern;
Figure 5 is a view showing main components of the imaging device according to the present embodiment;
Figure 6 is a view for describing birefringence of liquid crystal;
Figure 7 is a view showing a configuration example of the optical low pass filter according to the present embodiment;
Figure 8 is a view showing an example of a resolution conversion process performed by an output image signal generation unit;
Figure 9 is a view showing an example of a resolution conversion process performed by an output image signal generation unit;
Figure 10 is a view showing an example of a resolution conversion process performed by an output image signal generation unit;
Figure 11 is a view showing another configuration example of the optical low pass filter according to the present embodiment;
Figure 12 is a view showing a disposition of liquid crystal molecule of a light-polarizing liquid crystal layer shown in Figure 11;
Figure 13 is a view showing another configuration example of the optical low pass filter according to the present embodiment;
Figure 14 is a view showing another configuration example of the optical low pass filter according to the present embodiment; and
Figure 15 is a view showing another configuration example of the optical low pass filter according to the present embodiment.

### Best Mode for Carrying Out the Invention

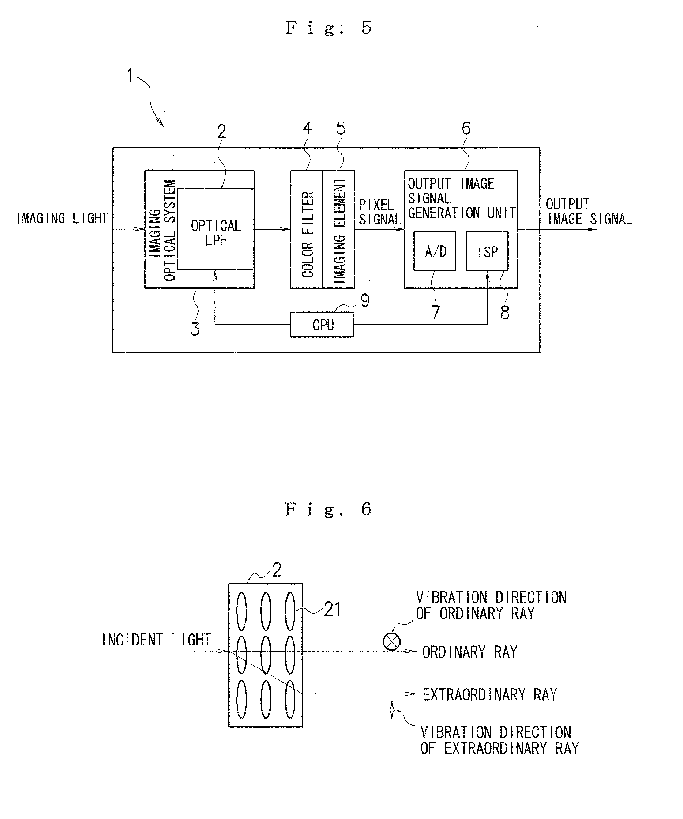

One embodiment of the present invention will be described below based on the drawings. Figure 5 is a view showing main components of an imaging device 1 according to the present embodiment. The imaging device 1 according to the present embodiment includes an imaging optical system 3 equipped with an optical low pass filter 2, a color filter 4 for decomposing an imaging light outputted from this imaging optical system 3 into predetermined color components, an imaging element 5 for photoelectrically converting the imaging light having passed through this color filter 4 and generating the pixel signal, an output image signal generation unit 6 equipped with an A/D converter 7 and an ISP 8 (Image Signal Processor) for generating the output image signal based on the pixel signal obtained from this imaging element 5, and a CPU 9 (Central Processing Unit) for controlling the optical low pass filter 2 and the ISP 8 inside the output image signal generation unit 6.

The optical low pass filter 2 plays a role of suppressing a high spatial frequency component in imaging light. The optical low pass filter 2 according to the present embodiment is, for example, composed of the birefringent plate made of liquid crystal as a base material, and is disposed in front of the imaging element 5 on the optical path of the imaging light. When the dielectric constant of the material is anisotropic, an incident light on that material is separated into two lights different in the polarization direction by a relationship with its vibration direction.

As shown in Figure 6, when the optical low pass filter 2 is the birefringent plate made of liquid crystal, the incident light on the birefringent plate is separated into a light (ordinary ray) vibrating in a direction vertical to a polarization direction (a long axis direction) of liquid crystal molecule 21 and a light (extraordinary ray) vibrating in a direction in parallel with the polarization direction of the liquid crystal molecule 21. In Figure 6, the ordinary ray is depicted as a polarized light vibrating vertical to a paper face, whereas the extraordinary ray is depicted as a polarized light vibrating inside the paper face.

Further, in the present embodiment, depending on which of the still image capturing mode or the dynamic image capturing mode is set, the frequency characteristic of the optical low pass filter 2 is switched over. The switching over of the frequency characteristic of the optical low pass filter 2 is realized by variously controlling a distance (referred to as a light beam separation width) between the ordinary ray and the extraordinary ray in the birefringent plate. When the light beam separation width becomes larger, the cut-off frequency of the optical low pass filter 2 becomes lower, and the blur condition of the image formed in the imaging element 5 becomes larger. On the contrary, when the light beam separation width becomes smaller, the cut-off frequency of the optical low pass filter 2 becomes higher, and the blur condition of the image formed in the imaging element 5 becomes smaller.

Here, at the time of the still image capturing mode, the light beam separation width is taken as a first width, thereby to take the blur condition of the image as a first amount, and at the time of the dynamic image capturing mode, the light beam separation width is taken as a second width wider than the first width, so that the blur condition of the image is taken as a second amount larger than the first amount. When the color filter 4 is disposed in the Bayer pattern as shown in Figure 4, at the time of the still image capturing mode, the first width is set to a width in which the cut-off frequency of the optical low pass filter 2 becomes approximately fs/2 (=1/2d) or slightly exceeds this frequency in order to prioritize high resolution and to minimize the suppression of the false color.

Further, at the time of the dynamic image capturing mode, in order to cut the high frequency component equivalent to the resolution component unnecessary for the output image signal and to strongly and sufficiently perform the suppression of the false color, the second width is set to a frequency in which the cut-off frequency of the optical low pass filter 2 is equivalent to the Nyquist frequency of the pixel of the output image or set to a width slightly exceeding this frequency.

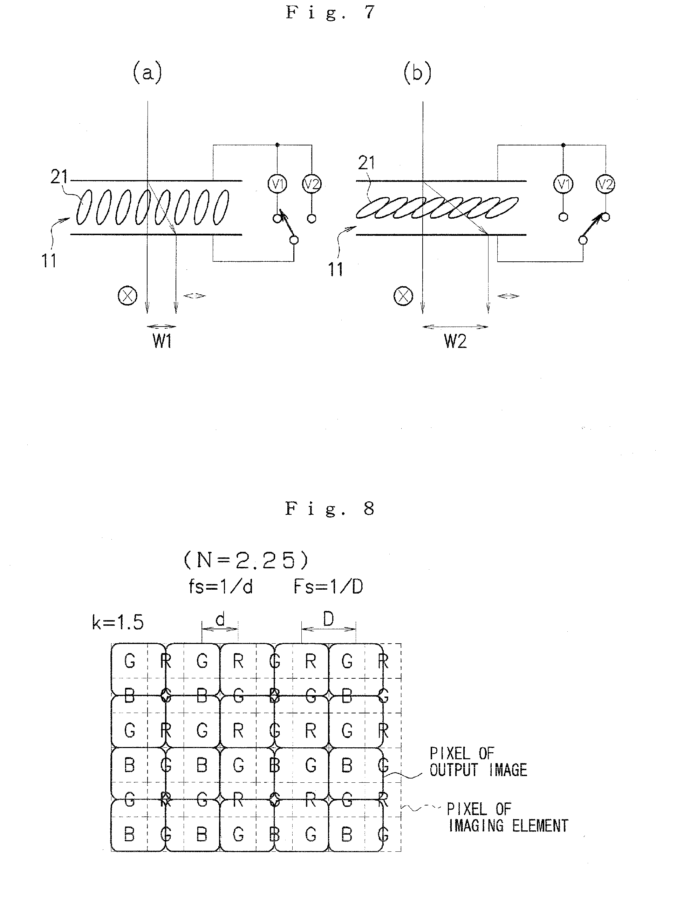

The light beam separation width at the optical low pass filter 2 is made variable by controlling the voltage applied to the liquid crystal. That is, as shown in Figure 7, the optical low pass filter 2 according to the present embodiment, for example, includes a birefringent layer 11 (equivalent to a varifocal layer of the present invention) made of the liquid crystal as a base material. The liquid crystal of the birefringent layer 11 changes the orientation direction of the liquid crystal molecule 21 by a size of its applied voltage, and changes a refraction index for the extraordinary ray. By utilizing such a field controlled birefringent effect, the light beam separation width of the optical low pass filter 2 can be changed.

As shown in Figure 7(a), when a relatively small voltage V1 is applied to the liquid crystal of the birefringent layer 11, the inclination of the liquid crystal molecule 21 becomes small for an incident light axis, so that the light beam separation width becomes a relatively narrow first width W1. Further, as shown in Figure 7(b), when a relatively large voltage V2 (V1<V2) is applied to the liquid crystal of the birefringent layer 11, the inclination of the liquid crystal molecule 21 becomes large for the incident light axis, so that the light beam separation width becomes a relatively wide second width W2 (W1<W2).

The imaging optical system 3 plays a role of guiding the imaging light to the imaging element 5. In the present embodiment, the system 3 includes the optical low pass filter 2, and is formed of an imaging lens, an infrared removing filter, and the like. The infrared removing filter blocks an infrared ray incident on a photo diode, and is disposed in front of the optical low pass filter 2, and is formed as a panel of glass block.

The color filter 4 is regularly disposed in the predetermined pattern on the light receiving surface of each pixel forming the imaging element 5, and plays a role of filtering the imaging light into the predetermined color components. In the present embodiment, as three colors of a first color, a second color, and a third color forming the color filter 4, the primary color filters for R, G, and B colors are used. However, this is not limitative, and complementary color filters formed of C (cyan), M (Magenta), and Y (Yellow) and a combination of other colors may be used. Moreover, a filter of an emerald color may be added to the three color filters.

Further, in the present embodiment, as a disposition pattern of the color filter 4, as shown in Figure 4, a Bayer pattern wherein the G color filter is disposed in a checkered pattern and the R color filter and the B color filter are disposed alternately on each row is used. However, the disposition thereof is not limited to this pattern.

The imaging element 5 plays a role of photoelectrically converting the received imaging light into electric image information, and storing it as an electric charge amount to be outputted to the output image signal generation unit 6 as an electrical signal. The imaging element 5 has a plurality of pixels (photo diodes) disposed in the predetermined pattern, and regularly disposes the color filters 4 in the predetermined pattern on the light receiving surface of each pixel. The number of pixels of the imaging element 5 according to the present embodiment is set to the number (for example, N times the number of display pixels of HD standards or more (N is a real number of 2 or more)) which is more than the number (for example, approximately 350,000 pixels according to the SD standards, and 2,080,000 pixels also according to the HD standards) of display pixels set up by the standards of the dynamic image.

The output image signal generation unit 6 plays a role of A/D converting the pixel signal obtained from each pixel of the imaging element 5, and performing various image processings, and generating the output image signal. The output image signal generation unit 6 is formed of the A/D converter 7 and the ISP 8, and is electrically connected to the imaging element 5. The A/D converter 7 converts the pixel signal which is an analogue electric signal into digital data.

The CPU 9 performs a control of the voltage applied to the liquid crystal of the optical low pass filter 2 and a control of switching the image capturing mode for the ISP 8. That is, at the time of the still image capturing mode, the CPU 9 applies a voltage V1 to the liquid crystal, and at the same time, performs a control of setting the still image capturing mode for the ISP 8. Further, at the time of the dynamic image capturing mode, the CPU 9 applies a voltage V2 to the liquid crystal, and at the same time, performs a control of setting the dynamic image capturing mode for the ISP 8. The ISP 8 performs various image processings such as optical black processing, white balance processing, color correction processing, color interpolation processing, noise suppression processing, contour enhancement processing, γ correction processing, and resolution conversion processing for the A/D converted pixel signal, and generates an output image signal. At this time, the ISP 8, in response to the imaging mode set from the CPU 9, performs image processing for the still image or the dynamic image.

The resolution conversion processing is executed, for example, only when the dynamic image capturing mode is set. A conversion ratio of the resolution conversion processing is set such that N pieces of the A/D converted pixel signals are made equivalent to one piece of the output image signal. That is, at the time of still image capturing mode, the ISP 8 generates N pieces of the output image signals from N pieces of the pixel signals generated by the imaging element 5, and at the time of the dynamic image capturing mode, generates one piece of the output image signal from N pieces of the pixel signals generated by the imaging element 5. Even at the time of the still image capturing mode, if required by the user, the resolution conversion processing may be performed.

Here, a specific example of the processing for generating one piece of the output image signal from N pieces of the pixel signals will be described. Figures 8 to 10 are views showing the content example of the resolution conversion processing by the ISP 8. In these Figures 8 to 10, a relationship between the pixel disposition of the imaging element 5 and the pixel disposition of the output image and a relationship between the pixel pitch d (=1/fs) of the imaging element 5 and the pixel pitch D (=1/Fs) of the output image are shown.

As shown in Figure 8, when a ratio k of the pixel pitch D of the output image to the pixel pitch d of the imaging element 5 is taken as 1.5 (D=1.5d), the pixel signals equivalent to 2.25 pieces for the output image signal of one pixel are sampled, and therefore, a conversion ratio in the resolution conversion processing of the ISP 8, that is, the equivalent number N of the pixel signals used for generating the output image signal of one pixel is 2.25.

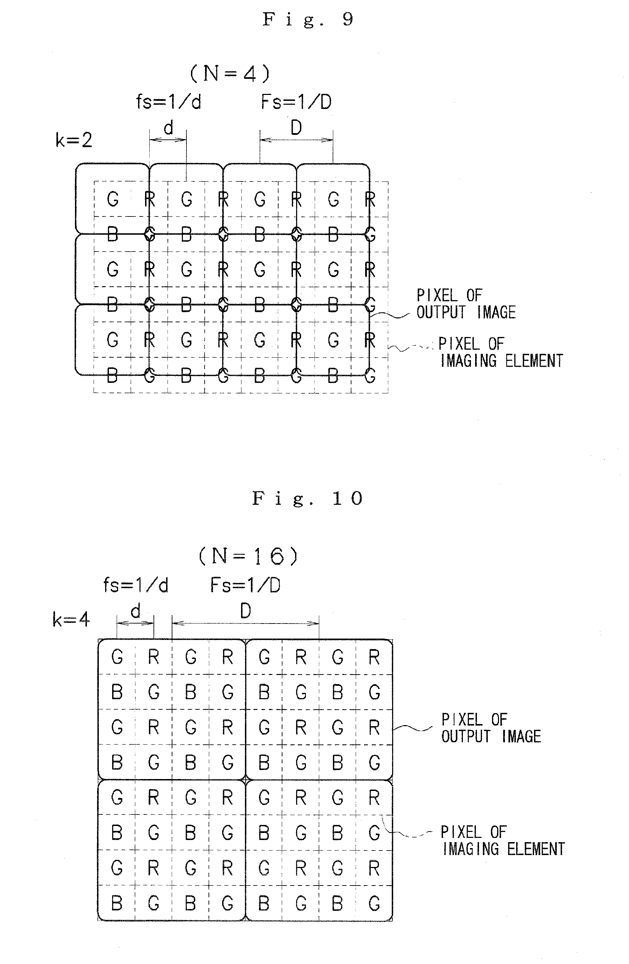

Further, as shown in Figure 9, when a ratio k of the pixel pitch D of the output image to the pixel pitch d of the imaging element 5 is taken as 2 (D=2d), the pixel signals equivalent to 4 pieces for the output image signal of one pixel are sampled, and therefore, N is 4. Further, as shown in Figure 10, when a ratio k of the pixel pitch D of the output image to the pixel pitch d of the imaging element 5 is taken as 4 (D=4d), the pixel signals equivalent to 16 pieces for the output image signal of one pixel are sampled, and therefore, N is 16.

The ISP 8 according to the present embodiment is, for example, formed of a CPU, a DSP (Digital Signal Processor) or a hard wired logic. Alternatively, the A/D converted pixel signal is loaded to a PC (personal computer), and the image processing may be performed by various programs.

Next, the operation of the imaging device according to the present embodiment thus configured will be described. First, when the still image capturing mode is set, as shown in Figure 7(a), a voltage V1 is applied to the liquid crystal of the optical low pass filter 2, and is controlled such that the light beam separation width becomes a relatively narrow first width W1. As a result, the cut-off frequency fc of the optical low pass filter 2 is set to approximately fs/2 (=1/2d) or to a level slightly exceeding this frequency.

As a result, the false color generated by the sampling in the imaging element 5 can be suppressed to a certain degree. Further, in this case, a filtering effect of the optical low pass filter 2 does not become too strong, and the shortage of the pixel signal of the imaging element 5 is not caused also. Thus, the lowering of the resolution at the optical low pass filter 2 can be suppressed as much as possible.

The imaging light having passed through the optical low pass filter 2 and the color filter 4 is image-formed at the imaging element 5, and by the photoelectric conversion, the pixel signal is generated. The pixel signal generated by the imaging element 5 is outputted to the output image signal generation unit 6, the output image signal is generated in the unit 6. At this time, from N pieces of the pixel signals generated by the imaging element 5, N pieces of the output image signals are generated. That is, with the resolution of the imaging element 5 used as it is, the output image signal of high resolution is generated.

On the other hand, when the dynamic image capturing mode is set, as shown in Figure 7(b), a voltage V2 is applied to the liquid crystal of the optical low pass filter 2, and is controlled such that the light beam separation width becomes a relatively wide second width W2. As a result, the cut-off frequency fc of the optical low pass filter 2 is set to a frequency equivalent to the Nyquist frequency of the pixel of the output image or to a level slightly exceeding this frequency. As a result, while maintaining a sufficient resolution in the output image, the generation of the false color can be suppressed stronger than the still image capturing mode.

The imaging light having passed through the optical low pass filter 2 and the color filter 4 is image-formed in the imaging element 5, and the pixel signal is generated by the photoelectric conversion. The pixel signal generated by the imaging element 5 is outputted to the output image signal generation unit 6, the output image signal is generated in the unit 6. At this time, from N pieces of the pixel signal generated by the imaging element 5, one piece of the output image signal is generated.

That is, N pieces of the pixel signals, obtained by the imaging element 5 wherein the number of pixels is set larger than the number of display pixels required by the standards of the dynamic image so as that the number of pixels sufficient for the dynamic image exists, generates the output image signals corresponding to the number of the display pixels. As a result, even when the resolution is reduced by the optical low pass filter 2 set low in the cut-off frequency fc, since the high-frequency component equivalent to the resolution originally unnecessary for the output image signal is merely cutoff at the time of the generation of the output image signal, the display resolution required by the standards of the dynamic image can be sufficiently satisfied.

As described above in detail, according to the present embodiment, at the time of the still image capturing mode, the still image with the minimally-suppressed false color and high resolution can be obtained. Further, at the time of the dynamic image capturing mode, the dynamic image with the display resolution satisfying the requirements under the dynamic image standard and the effectively-suppressed false color can be obtained. Further, according to the present embodiment, by controlling the voltage applied to the liquid crystal of the optical low pass filter 2, the light beam separation width is changed, so that the frequency characteristic most appropriate to the still image capturing mode and the frequency characteristic most appropriate to the dynamic image capturing mode can be simply switched over.

In the above described embodiment, though a description has been made that the optical low pass filter 2 is composed of the birefringent plate made of the liquid crystal as a base member, the present invention is not limited to this. That is, if a material has a birefringent effect of the light and can electrically control the light beam separation width, it can be applied as a raw material of the optical low pass filter 2.

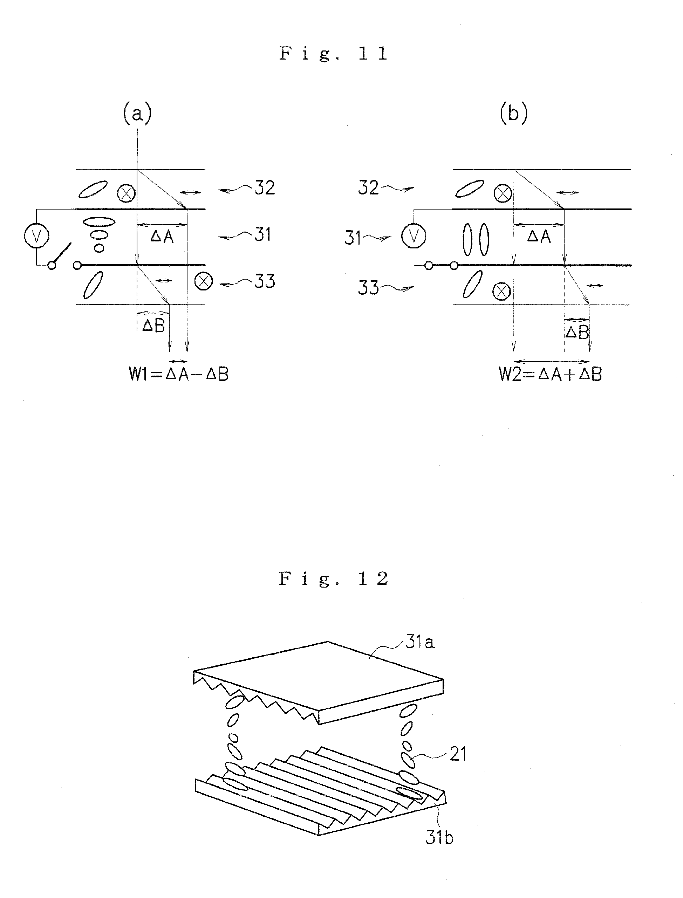

Further, in the above described embodiment, as a configuration example of the optical low pass filter 2, though a description has been made on an example in which a birefringent index is dynamically changed by a piece of the liquid crystal plate as shown in Figure 7, the present invention is not limited to this. For example, as shown in Figure 11, the configuration may be changed such that the birefringent index is dynamically changed by a plurality of liquid crystal plates.

In the example of Figure 11, the optical low pass filter 2 includes a polarization liquid crystal layer 31 of a twist nematic type capable of controlling a polarization state of the incident light (rotary polarization) and a pair of liquid crystal layers 32 and 33 (equivalent to a pair of birefringent layers according to claim 5) disposed respectively at the incident side and the outgoing side of the polarization liquid crystal layer 31 and separating the incident light into the ordinary ray and the extraordinary ray, thereby to be outputted. The inclined directions of the crystal axis of the liquid crystal layers 32 and 33 may be the same to each other or different from each other. By the polarization liquid crystal layer 31 and a pair of the liquid crystal layers 32 and 33, the varifocal layer of the present invention is formed.

In the example of Figure 11, according to the still image capturing mode or the dynamic image capturing mode, the separation width of the output light beam, obtained when the incident light for one liquid crystal layer 32 passes through the polarization liquid crystal layer 31 and a pair of the liquid crystal layers 32 and 33, is made as a first width W1 shown in Figure 11(a) at the still image capturing mode and is made as a second width W2 shown in Figure 11(b) at the time of the dynamic image capturing mode by variably controlling the polarization state in the polarization liquid crystal layer 31.

Figure 12 is a view showing the disposition of the liquid crystal molecules 21 of the polarization liquid crystal layer 31. As shown in Figure 12, when the liquid crystal is brought into contact with the orientation films 31a and 31b having unidirectional micro grooves, the liquid crystal molecules 21 are disposed along the grooves. By sandwiching the liquid crystal by two orientation films 31a and 31b which have changed the direction of the grooves by 90 degrees, the liquid crystal molecule2 21 are twistedly disposed by 90 degrees in the liquid crystal layer. When the light is let pass through the liquid crystal in a state in which the disposition of the liquid crystal molecules 21 are twisted by 90 degrees, the light passes through by being twisted by 90 degrees along the gap in which the liquid crystal molecules 21 are lined up. As a result, the vibration direction of the light changes by 90 degrees before and after passing through the polarization liquid crystal layer 31.

When a voltage is applied to such polarization liquid crystal layer 31, the disposition of the liquid crystal molecules 21 are changed. That is, the liquid crystal molecules 21 are disposed by having an angle corresponding to a size of the voltage applied to the orientation films 31a and 31b. In the present embodiment, the CPU 9, by controlling the presence or absence of the applied voltage, as shown in Figure 11, performs a control such that the liquid crystal molecules 21 are set either 0 degree (parallel angles) or 90 degrees (right angles) to the orientation films 31a and 31b.

In the case of the optical low pass filter 2 shown in Figure 11, the incident light is first separated into the ordinary ray and the extraordinary ray by one liquid crystal layer 32, and is emitted by being separated by ΔA spatially. In Figure 11, the ordinary ray is depicted as a polarized light vibrating vertical to a paper face, and the extraordinary ray is depicted as a polarized light vibrating inside a paper face. The ordinary ray and the extraordinary ray separated by one liquid crystal layer 32 subsequently enter the polarization liquid crystal layer 31.

Here, as shown in Figure 11(a), when the voltage applied to the polarization liquid crystal layer 31 is turned off, the liquid crystal molecules 21 are in parallel with the orientation films 31a and 31b. Hence, the imaging light having passed through one liquid crystal layer 32 is twisted by 90 degrees by passing through the polarization liquid crystal layer 31. Therefore, an aspect of the vibrating surface with the ordinary ray and the extraordinary ray incident on the polarization liquid crystal layer 31 changes. Here, since the aspect of the vibrating surface changes by 90 degrees, the ordinary ray emitted from one liquid crystal layer 32 becomes an extraordinary ray for the other liquid crystal layer 33, and the extraordinary ray emitted from one liquid crystal layer 32 becomes the ordinary ray for the liquid crystal layer 33.

Therefore, the ordinary ray emitted from one liquid crystal layer 32 is emitted by being displaced by ΔB by the other liquid crystal layer 33, and the extraordinary ray emitted from one liquid crystal layer 32 is emitted by being not displaced by the other liquid crystal layer 33. As a result, here, since ΔA>ΔB, the first width W1 which is the light beam separation width as the whole of the optical low pass filter 2 becomes W1=ΔA-ΔB.

On the other hand, as shown in Figure 11(b), when the voltage applied to the polarization liquid crystal layer 31 is turned on, the liquid crystal molecules 21 are vertical to the orientation films 31a and 31b. Hence, the imaging light having passed through one liquid crystal layer 32 passes through the polarization liquid crystal layer 31 without being twisted. Therefore, the ordinary ray emitted from one liquid crystal layer 32 becomes an ordinary ray also for the other liquid crystal layer 33, and the extraordinary ray emitted from one liquid crystal layer 32 becomes the extraordinary ray also for the other liquid crystal layer 33.

Hence, the ordinary ray emitted from one liquid crystal layer 32 is emitted without being displaced even by the other liquid crystal layer 33, and the extraordinary ray emitted from one liquid crystal layer 32 is emitted by being further displaced by ΔB by the other liquid crystal layer 33. As a result, the second width W2 which is the light beam separation width as the whole of the optical low pass filter 2 becomes W2=ΔA+ΔB.

When the optical low pass filter 2 is configured as Figure 11, by the presence or absence of the voltage applied to the polarization liquid crystal layer 31, the light beam separation width can be variably controlled. Hence, it is not necessary to prepare two different applied voltages V1 and V2 similarly to the example of Figure 7. Further, in the case of Figure 7, though it is necessary to apply the voltage even when any of the still image capturing mode and the dynamic image capturing mode is set, in the case of Figure 11, it is not necessary to apply the voltage at the time of the still image capturing mode, and therefore, the low power consumption can be achieved.

In the case of Figure 11, the liquid crystal layers 32 and 33 are used as an example of a pair of birefringent layers. However, instead of the liquid crystal, quartz crystal, lithium niobate, and the like may be used.

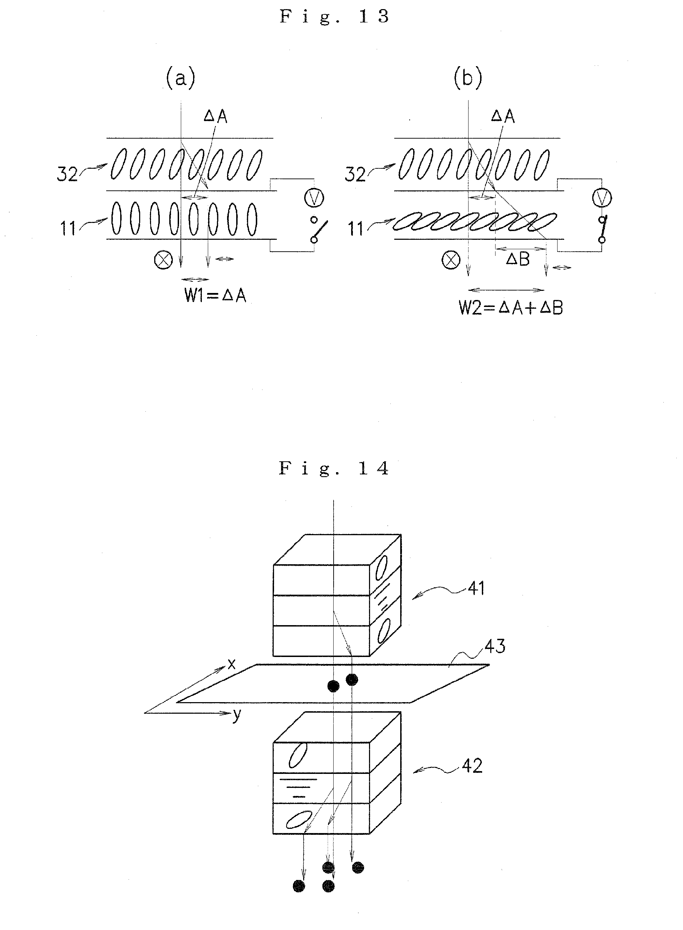

Further, in the case of Figure 11, a pair of the liquid crystal layers 32 and 33 is disposed at the incident side and the outgoing side of the polarization liquid crystal layer 31, but this is not limitative. For example, as shown in Figure 13, by superposing two liquid crystal layers 11 and 32, the optical low pass filter 2 may be formed. That is, in the configuration shown in Figure 13, at the incident side of the same liquid crystal layer 11 (equivalent to the first birefringent layer in Claim 6) as Figure 7, the same liquid crystal layer 32 (equivalent to the second birefringent layer in Claim 6) as Figure 11 is provided. The crystal axis of the liquid crystal layer 32 located at the upper layer is inclined to an optical axis of the incident light with the predetermined angle given. Further, the inclination of the crystal axis of the liquid crystal layer 11 located at the lower layer changes according to the presence or absence of the applied voltage.

In the case of Figure 13, by controlling the presence or absence of the voltage applied to the liquid crystal layer 11 of the lower layer according to the still image capturing mode or the dynamic image capturing mode, a separation width of the output light, obtained when the incident light on the liquid crystal layer 32 of the upper layer passes through the liquid crystal layer 11 of the lower layer, is taken as a first width W1 shown in Figure 13(a) at the time of the still image capturing mode and is taken as a second width W2 shown in Figure 13(b) at the time of the dynamic image capturing mode.

In the case of the optical low pass filter 2 shown in Figure 13, the incident light is first separated into the ordinary ray and the extraordinary ray by the liquid crystal layer 32 of the upper layer, and is emitted by being separated by ΔA spatially. In Figure 13, the ordinary ray is depicted as a polarized light vibrating vertical to a paper face, and the extraordinary ray is depicted as a polarized light vibrating inside a paper face. The ordinary ray and the extraordinary ray separated by the liquid crystal layer 32 of the upper layer enter the liquid crystal layer 11 of the lower layer.

Here, as shown in Figure 13(a), when the voltage applied to the liquid crystal layer 11 of the lower layer is turned off, the liquid crystal molecules are in parallel with the optical axis of the incident light. Hence, both of the ordinary ray and the extraordinary ray emitted from the liquid crystal layer 32 of the upper layer are emitted without being displaced by the liquid crystal layer 11 of the lower layer. As a result, a first width W1 which is the light beam separation width as the whole of the optical low pass filter 2 becomes W1=ΔA.

On the other hand, as shown in Figure 13(b), when the voltage applied to the liquid crystal layer 11 of the lower layer is turned on, the liquid crystal molecules line up with a certain degree of inclination to an optical axis of the incident light. Hence, the ordinary ray emitted from the liquid crystal layer 32 of the upper layer is emitted without being displaced even by the liquid crystal layer 11 of the lower layer. However, the extraordinary ray emitted from the liquid crystal layer 32 of the upper layer is emitted by being further displaced by ΔB by the liquid crystal layer 11 of the lower layer. As a result, a second width W2 which is the light separation width as the whole of the optical low pass filter 2 becomes W2=ΔA+ΔB.

When the optical low pass filter 2 is configured as Figure 13, the light beam separation width can be variably controlled by the presence or absence of the voltage applied to the liquid crystal layer 11 of the lower layer. Hence, it is not necessary to prepare two different applied voltages V1 and V2. Further, it is not necessary to apply the voltage at the time of the still image capturing mode, and the low power consumption can be achieved.

In the case of Figure 13, as an example of the birefringent layer disposed at the incident side of the liquid crystal layer 11, the liquid crystal layer 32 is used. However, instead of the liquid crystal, quartz crystal, lithium niobate, and the like may be used. Further, in Figure 13, though an example of disposing the liquid crystal layer 32 at the incident side of the liquid crystal layer 11 is shown, the liquid crystal layer 32 may be disposed at the emitting side of the liquid crystal layer 11. Further, similarly to the case of Figure 7, it is not always necessary for the liquid crystal layer 11 also to use the liquid crystal as a base material. That is, if a material has a birefringent effect of the light, and can electrically control the light beam separation width, it can be used in place of the liquid crystal layer 11.

Figure 14 is a view showing another configuration example of the optical low pass filter 2. The optical low pass filter 2 shown in Figure 14 includes two low pass filters 41 and 42 each with a three-layer structure shown in Figure 11, being superposed so as that each plane including the crystal axis is mutually in an orthogonal state or an oblique state, and a 1/4 wave plate 43 (acts to change a linear polarized light into a circular polarized light), being disposed between both filters.

In the optical low pass filter 2 shown in Figure 14, by an optical low pass filter 41 of a first stage, the incident light is separated into the ordinary ray and the extraordinary ray along an x axis direction, and by the 1/4 wave plate 43, the linear polarized light incident from the optical low pass filter 41 is changed to the circular polarized light. By an optical low pass filter 42 of a second stage, two incident lights from the 1/4 wave plate 43 are separated into the ordinary ray and the extraordinary ray respectively along a y axis, so that these rays are two-dimensionally separated into four pieces of the lights.

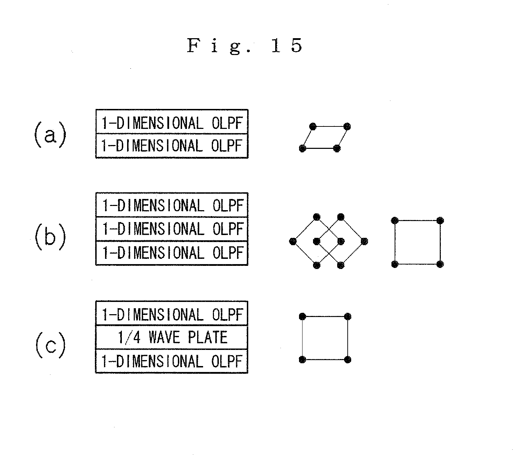

The configuration in which one piece of the incident light is two-dimensionally separated into a plurality of lights is not limited to the configuration similarly to Figure 14. For example, it can be made into a configuration such as shown in Figure 15. In Figure 15, a black circle shows a positional relationship among a plurality of lights to be separated.

The configuration of Figure 15(a) includes two one-dimensional optical low pass filters having the configuration shown in Figures 7, 11 or 13, and these filters are overlapped so as that each plane including the crystal axis is mutually in an orthogonal state or an oblique state. The two one-dimensional optical low pass filters disposed to be mutually superposed may adopt any one of the configurations of Figures 7, 11, and 13 so as to have the same configuration respectively or adopt any two configurations of Figures 7, 11, and 13 so as to have a different configuration to each other.

The configuration of Figure 15(b) includes three one-dimensional optical low pass filters having the configuration shown in Figures 7, 11 or 13, and these filters are overlapped so as that each plane including the crystal axis is mutually in an orthogonal state or an oblique state. The three one-dimensional optical low pass filters disposed to be mutually superposed may adopt any one of the configurations of Figures 7, 11, and 13 so as to have the same configuration respectively or adopt any two or three configurations of Figures 7, 11, and 13 so as to combine them in desired order.

The configuration of Figure 15(c) includes two one-dimensional optical low pass filters having the configuration shown in Figures 7, 11 or 13, these filters are overlapped so as that each plane including the crystal axis is mutually in an orthogonal state or an oblique state, and the 1/4 wave plate being disposed between both filters. The two one-dimensional optical low pass filters disposed at both sides of the 1/4 wave plate mutually superposed may adopt any one of the configurations of Figures 7, 11, and 13 so as to have the same configuration respectively or adopt any two configurations of Figures 7, 11, and 13 so as to combine them. An example in which the one-dimensional optical low pass filters having the configuration of Figure 11 are disposed mutually at both sides of the 1/4 wave plate is equivalent to the configuration of Figure 14.

Further, in the above described embodiment, as an example of the varifocal layer variably changing the blur condition of the image formed in the imaging element 5, though a description has been made on the example using the birefringent plate made of the liquid crystal and the like as a base material, the present invention is not limited to this. For example, the varifocal layer may be formed of the liquid crystal lens.

The liquid crystal lens is a kind of lens utilizing the liquid crystal. When the liquid crystal is sealed into a lenticular space and the voltage to be applied is adjusted, an apparent refraction index of the liquid crystal changes. Even if it is a lens of the same shape, when the refraction index of the liquid crystal which forms the lens changes, a focal length of the lens changes. Thus, when the liquid crystal lens is employed, the focal length of the lens can be changed by a control of the electrical signal only.

When the liquid crystal lens is used as the varifocal layer, by controlling the voltage applied to the liquid crystal lens according to the still image capturing mode or the dynamic image capturing mode, the focal length can be variably changed through the change of the refraction index of the liquid crystal lens. As a result, at the time of the still image capturing mode, the blur condition of the image is taken as a first amount, and at the time of the dynamic image capturing mode, the blur condition of the image is taken as a second amount.

Further, in the above described embodiment, while a description has been made on the case as an example, in which the pixel disposition of the imaging element 5 is in a square lattice pattern, this is not limitative. For example, the disposition may be in a square lattice pattern inclined 45°.

In the above described embodiment, the setting of the still image capturing mode and the dynamic image capturing mode can be performed by operating a mode setting operation key (not shown), which is provided in the imaging device 1, by a user. Further, even during the taking the dynamic image by setting the dynamic image capturing mode by the user, when the user pushes down an shutter for the still image, it is possible to automatically switch over the mode to the still image capturing mode for the meantime. Mode information thus set up is stored in a memory (not shown) of the imaging device 1. The CPU 8, by referring to the mode information thus stored in the memory, controls the voltage applied to the optical low pass filter 2.

In addition, the above described embodiment has only shown an example of the embodiments at the time of executing the present invention, and it is to be expressively understood that this is not intended as the limits of the scope of the present invention. That is, the present invention can be executed in various forms without being deviated from the spirit or the main features of the invention.

### Industrial Applicability

The optical low pass filter of the present invention is useful for a hybrid camera made capable of taking both the dynamic image and the still image by one set of the camera.

## Claims

1. An optical low pass filter,
a blur condition of an image image-formed in an imaging element is variably controlled according to a still image capturing mode or a dynamic image capturing mode, so that, at the time of said still image capturing mode, said blur condition of the image is taken as a first amount, and at the time of said dynamic image capturing mode, said blur condition of the image is taken as a second amount larger than said first amount.

2. The optical low pass filter according to claim 1, comprising:
a varifocal layer changing in refraction index of the light according to a voltage to be applied and changing in said blur condition of the image,
said blur condition of the image is configured to be switchable electronically by the voltage applied to said varifocal layer.

3. The optical low pass filter according to claim 2,
said varifocal layer comprises a liquid crystal lens, and
the voltage applied to said liquid crystal lens is controlled according to said still image capturing mode or said dynamic image capturing mode, and the focal length is variably controlled through a change of the refraction index of said liquid crystal lens, thereby electronically switching said blur condition of the image.

4. The optical low pass filter according to claim 2,
said varifocal layer comprises a birefringent layer separating an incident light into an ordinary ray and an extraordinary ray and outputting the same, and
the voltage applied to said birefringent layer is controlled according to said still image capturing mode or said still image capturing mode, and light beam separation widths of said ordinary ray and said extraordinary ray outputted from said birefringent layer are variably controlled, so that at the time of said still image capturing mode, said light beam separation width is taken as a first width, thereby taking said blur condition of the image as said first amount, and at the time of said dynamic image capturing mode, said light beam separation width is taken as a second width wider than said first width, thereby taking said blur condition of the image as said second amount.

5. The optical low pass filter according to claim 2,
said varifocal layer comprises a polarization liquid crystal layer capable of controlling a polarized state of the incident light and a pair of birefringent layers disposed respectively at an incident side and an outgoing side of said polarization liquid crystal layer and separating the incident light into the ordinary ray and the extraordinary ray so as to be outputted, and
the voltage applied to said polarization liquid crystal layer is controlled according to said still image capturing mode or said dynamic image capturing mode, and by variably controlling a polarized state in said polarization liquid crystal layer, the separation width of the output light obtained when the incident light passes through said polarization liquid crystal layer and said pair of the birefringent layer is taken as a first width at the time of the still image capturing mode, thereby taking said blur condition of the image as said first amount, and is taken as a second width wider than said first width at the time of said dynamic image capturing mode, thereby taking said blur condition of the image as said second amount.

6. The optical low pass filter according to claim 2,
said varifocal layer comprises a first birefringent layer separating the incident light into the ordinary ray and the extraordinary ray and outputting the same and a second birefringent layer disposed at least at one of the incident side and the outgoing side of said first birefringent layer and separating the incident light into the ordinary ray and the extraordinary ray so as to be outputted, and
the voltage applied to said first birefringent layer is controlled according to said still image capturing mode or said dynamic image capturing mode, and by variably controlling the light beam separation widths of said ordinary ray and said extraordinary ray outputted by said first birefringent layer, the separation width of the output light obtained when the incident light passes through said first and second birefringent layers is taken as a first width at the time of said still image capturing mode, thereby taking said blur condition of the image as said first amount, and is taken as a second width wider than said first width at the time of said dynamic image capturing mode, thereby taking said blur condition of the image as said second amount.

7. An optical low pass filter, comprising:
two optical low pass filters according to claim 4 which are disposed so as that each plane including the crystal axis is mutually overlapped in an orthogonal state or an oblique state.

8. An optical low pass filter, comprising:
three optical low pass filters according to claim 4 which are disposed so as that each plane including the crystal axis is mutually overlapped in an orthogonal state or an oblique state.

9. An optical low pass filter, comprising:
two optical low pass filters according to claim 4 which are disposed so as that each plane including the crystal axis is mutually overlapped in an orthogonal state or an oblique state; and
a 1/4 wave plate for converting a linear polarized light into a circular polarized light being disposed between said two optical low pass filters.

10. An imaging device, comprising:
the optical low pass filter according to claim 1;
an imaging element image-forming an imaging light having passed through said optical low pass filter and generating a pixel signal by photoelectrical conversion; and
an output image signal generation unit for generating an output image signal from the pixel signal generated by said imaging element, said output image signal generation unit generating one piece of the output image signal from N pieces of the pixel signals (N is a real number of 2 or more) generated by said imaging element at the time of said dynamic image capturing mode,
the number of pixels of said imaging element is set larger than the number of display pixels set by the standards of the dynamic image.
